# EUROPEAN PATENT SPECIFICATION

(11) **EP 0 878 007 B1**
(45) Date of publication and mention of the grant of the patent: **11.05.2005**
(21) Application number: 97903876.7
(22) Date of filing: 22.01.1997
(51) Int. Cl.: G11C 19/28, H01L 31/0216, H04N 3/15

(54) **ACTIVE PIXEL SENSOR ARRAY WITH ELECTRONIC SHUTTERING**
AKTIVE BILDELEMENTSENSORMATRIX MIT ELEKTRONISCHER ÜBERBLENDUNG
RESEAU DE DETECTEURS A PIXELS ACTIFS OBTURABLES ELECTRONIQUEMENT

(30) Priority: 22.01.1996 US 10305 P; 20.03.1996 US 13700 P
(43) Date of publication of application: 18.11.1998
(60) Divisional application: 04077767.4
(73) Proprietor: CALIFORNIA INSTITUTE OF TECHNOLOGY, Pasadena California 91125 (US)
(72) Inventor: FOSSUM, Eric, R., La Crescenta, CA 91214 (US)
(74) Representative: Charig, Raymond Julian
(86) International application number: PCT/US1997/000927
(87) International publication number: WO 1997/028558

(56) References cited:
- EP-A- 0 683 602
- EP-A- 0 708 554
- GB-A- 2 269 505
- JP-A- 5 235 317
- US-A- 4 093 872
- US-A- 4 155 094
- US-A- 4 287 441
- US-A- 4 683 580
- US-A- 4 873 561
- US-A- 4 980 735
- US-A- 5 051 797
- US-A- 5 323 052
- US-A- 5 386 128
- US-A- 5 471 515
- US-A- 5 563 429
- US-A- 5 631 704
- PATENT ABSTRACTS OF JAPAN vol. 018, no. 566 (E-1622), 28 October 1994 (1994-10-28) & JP 06 205282 A (FUJI PHOTO FILM CO LTD), 22 July 1994 (1994-07-22) -& US 5 877 810 A (INUIYA ET AL) 2 March 1999 (1999-03-02)

## Description

### Origin of the Invention:

The invention described herein was made in the performance of work under a NASA contract, and is subject to the provisions of Public Law 96-517 (35 USC 202) in which the Contractor has elected to retain title.

### Related Applications:

This application is related to a continuation-in-part of U.S. patent application Serial No. 08/558,521, (US-A-6 101 232), which is a continuation of 08/188,032 filed January 28, 1994, (US-A-5 471 515), entitled ACTIVE PIXEL SENSOR WITH INTRA-PIXEL CHARGE TRANSFER by Eric R. Fossum et al. and assigned to the present assignee.
This application also claims priority from provisional application number 60/010,305, filed January 22, 1996, and from provisional application number 60/013,700, filed March 20, 1996.

### Field of the invention:

The invention is related to semiconductor imaging devices. More specifically, the present invention relates to a silicon imaging device which can be fabricated using a CMOS compatible process, and specific improved techniques that are used by such a system.

### Background and Summary:

Many semiconductors can be used for acquiring a signal indicative of an image. Charge coupled devices (CCDs), photodiode arrays, charge injection devices and hybrid focal plane arrays are some of the more commonly used devices. CCDs are often used, since they represent a mature technology, are capable of large formats and very small pixel size and they facilitate noise-reduced charge domain processing techniques such as binning and time delay integration.

However, CCD imagers suffer from a number of drawbacks. For example, the signal fidelity of a CCD decreases as the charge transfer efficiency is raised to the power of the number of stages. Since CCDs use many stages, the CCD fabrication technique needs to be optimized for very efficient charge transfer efficiency. CCDs are also susceptible to radiation damage, require good light shielding to avoid smear and have high power dissipation for large arrays.

The specialized CCD semiconductor fabrication process is intended to maximize the charge transfer efficiency of the CCD. This specialized CCD process, however, has been incompatible with the complementary metal oxide semiconductor ("CMOS") processing which has been conventionally used. The image signal processing electronics required for the imager are often fabricated in CMOS. Accordingly, it has been difficult to integrate on-chip signal processing electronics in a CCD imager, because of the incompatibility of the processing techniques. Because of this problem, the signal processing electronics has often been carried out off-chip.

Typically, each column of CCD pixels is transferred to a corresponding cell of a serial output register, whose output is amplified by a single on-chip amplifier (e.g.,, a source follower transistor) before being processed in off-chip signal processing electronics. This architecture limits the read-out frame rate which the on-chip amplifier can handle proportional to the number of charge packets divided by the number of pixels in the imager.

The other types of imager devices have problems as well. Photodiode arrays exhibit high kTC noise. The KTC noise makes it impractical to reset a diode or capacitor node to the same initial voltage at the beginning of each integration period. Photodiode arrays also suffer from lag. Charge injection devices also have high noise.

Hybrid focal plane arrays exhibit less noise but are prohibitively expensive for many applications and have relatively small array sizes.

In view of the inventors recognition of the above problems, it is one object of the present invention to provide an imager device which has the low kTC noise level of a CCD without the associated CMOS incompatibility and other above-described problems.

In addition, there is a need in imaging devices to control the integration or exposure time of the sensor. This control allows decreasing the integration time for imaging relatively bright objects to avoid saturating the pixels. Conversely, it is sometimes desirable to increase the integration time to increase the resolution of relatively dim objects.

Control of the integration time is also advantageous in video imaging applications where it is desired that this period be less than the inverse of the frame rate. Thus, if the integration period is T and the frame rate is f, it is desirable that T≤ 1/f.

Integration time has been controlled in the past with mechanical shutters. However, the mechanical nature of these devices made the shuttering imprecise. This caused the integration time to vary significantly. In addition, once configured, the mechanical-type shutters could not easily be adjusted, for example, to shutter a different portion of the array or to change adaptively. A controllable electronic shutter in each pixel cell would provide a more efficient, precise, and versatile way of setting the integration time of the array or a part of the array.

Furthermore, it is advantageous in some applications that some or all the pixels be integrated simultaneously for the same absolute period of time. This simultaneous integration prevents motion skew in the image by providing a "stop-action" or "snap shot" image. The alternative to simultaneous integration is to accumulate charge in only a portion of the pixel cells being employed to image an observed scene. For example, an imaging system might operate by scanning a row of the array at a time to produce an overall image. Thus, the resultant image has a series of lines, each of which represents a part of the observed scene at a different time. Obviously, if the scene is changing quickly enough, the image will be skewed as stated above. Therefore, this piecemeal method of creating an image would be inappropriate for certain quickly changing scenes. However, by integrating all the pixels in the array simultaneously and capturing the accumulated charge, a "snap shot" of the scene encompassing the period of integration can be obtained. The captured accumulated charge would then be readout and processed in some sequential method to create the desired image.

In view of the above, one aspect of the present invention, which is set out in the claims, is embodied in an imaging device formed as a monolithic complementary metal oxide semiconductor integrated circuit in an industry standard complementary metal oxide semiconductor process. The integrated circuit includes a focal plane array of pixel cells, each one of the cells including a photosensing element, e.g.,, a photogate, overlying the substrate for accumulating photo-generated charge in an underlying portion of the substrate and a charge coupled device section formed on the substrate adjacent the photogate having a sensing node and at least one charge coupled device stage for transferring charge from the underlying portion of the substrate to the sensing node.

In a preferred embodiment, the sensing node of the charge coupled device section includes a floating element -- e.g.,, a diffusion, and the charge coupled device stage includes a transfer gate overlying the substrate between the floating diffusion and the photogate. This preferred embodiment can further include apparatus for periodically resetting a potential of the sensing node to a predetermined potential, including a drain diffusion connected to a drain bias voltage and a reset gate between the floating diffusion and the drain diffusion, the reset gate connected to a reset control signal.

The imaging device also includes a readout circuit having at least an output transistor. Preferably, the output transistor is a field effect source follower output transistor formed in each one of the pixel cells, the floating diffusion being connected to its gate. Also, the readout circuit can further include a field effect load transistor connected to the source follower output transistor, and preferably a correlated double sampling circuit having an input node connected between the source follower output transistor and load transistor. The focal array of cells is also preferably organized by rows and columns, and the readout circuit has plural load transistors and plural correlated double sampling circuits. In this case, each cell in each column of cells is connected to a single common load transistor and a single common correlated double sampling circuit. These common load transistors and correlated double sampling circuits are disposed at the bottom of the respective columns of cells to which they are connected.

In the preferred implementation, charge is first accumulated under the photogate of a pixel cell. Next, the correlated double sampling circuit samples the floating diffusion after it has been reset. The accumulated charge is then transferred to the floating diffusion and the sampling process is repeated with the result stored at another capacitor. The difference between the two stored values represents the signal output. In accordance with a further refinement, this difference is corrected for fixed pattern noise by subtracting from it another difference sensed between the two values while they are temporarily shorted.

The imaging device can also have a micro-lens layer overlying the substrate. This micro-lens layer includes a refractive layer and individual lenses formed in the layer which are in registration with individual ones of the cells. Each of the individual lenses has a curvature for focusing light toward a photosensitive portion of the respective cell.

In addition, the imaging device can further include an electronic shutter formed on the substrate adjacent the photogate. This electronic shutter is capable of draining charge from the portion of the substrate underlying the photogate, thus preventing any accumulation thereof. Accordingly, when the electronic shutter is "closed" such that charge is being drained from the portion of the substrate under the photogate, the pixel cell is essentially deactivated. When the electronic shutter is in an "open" mode, charge is allowed to accumulate under the photogate and the cell operates as described above.

The electronic shutter is preferably set in the "open" mode such that whenever charge accumulates under the photogate to a predetermined maximum level, any excess drains into a special sink in the electronic shutter, rather than into the floating diffusion. In this way, the electronic shutter provides a way to control the integration period of the cell, as well as lateral anti-blooming.

In addition to the just-described benefits, other objectives and advantages of the present invention will become apparent from the detailed description which follows hereinafter when taken in conjunction with the drawing accompanying figures.

### BRIEF DESCRIPTION OF THE DRAWINGS

These and other aspects of the invention will now be described in detail with reference to the accompanying drawings, wherein:
FIG. 1 is a diagram illustrating the architecture of a preferred individual focal plane cell;
FIG. 2 is a plan view of an integrated circuit having a focal plane array of cells of the type illustrated in FIG. 1.
FIG. 3A is a schematic diagram of the cell of FIG. 1.
FIG. 3B is a plan view of an integrated circuit constituting a focal plane array of cells of a type similar to FIG. 1, showing the load FET and sampling circuit as common elements at the bottom of each array column.
FIG. 4 is a graph of the surface potential in the charge transfer section of the cell of FIG. 3A;
FIG. 5 is a cross-sectional view of an alternative embodiment of the focal plane array of FIG. 2 including a micro-lens layer.
FIG. 6A shows a polymer filter embodiment;
FIG. 6B shows a multiple chip, separate color embodiment;
FIG. 6C shows a phosphor converting embodiment;

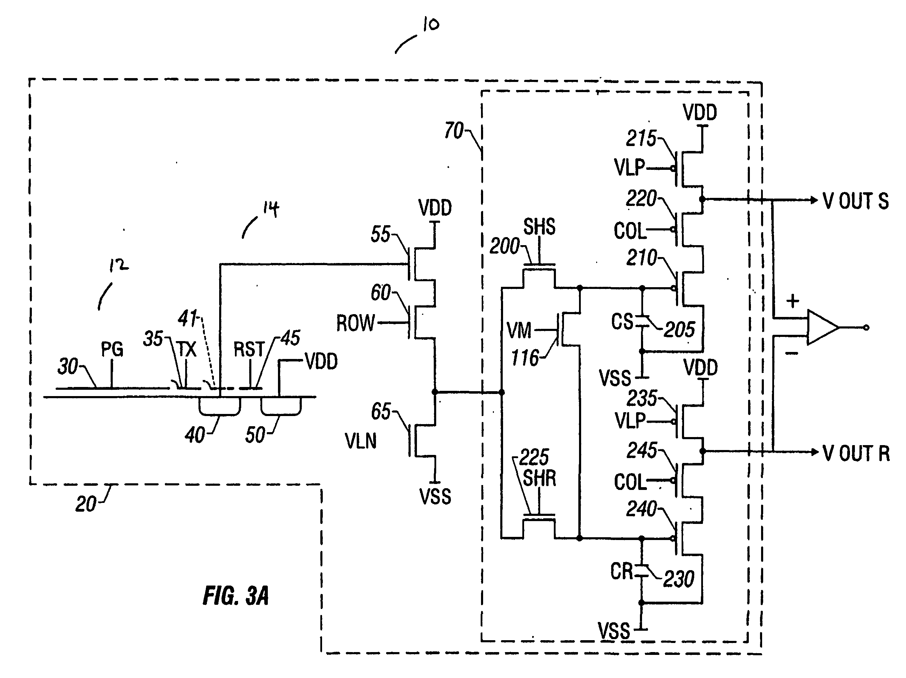

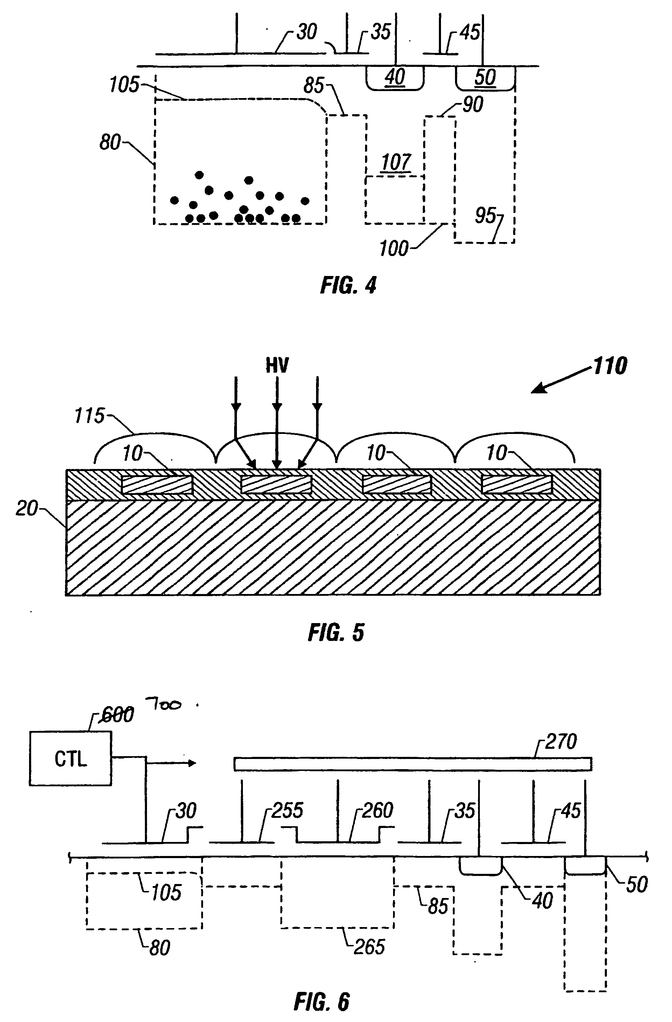

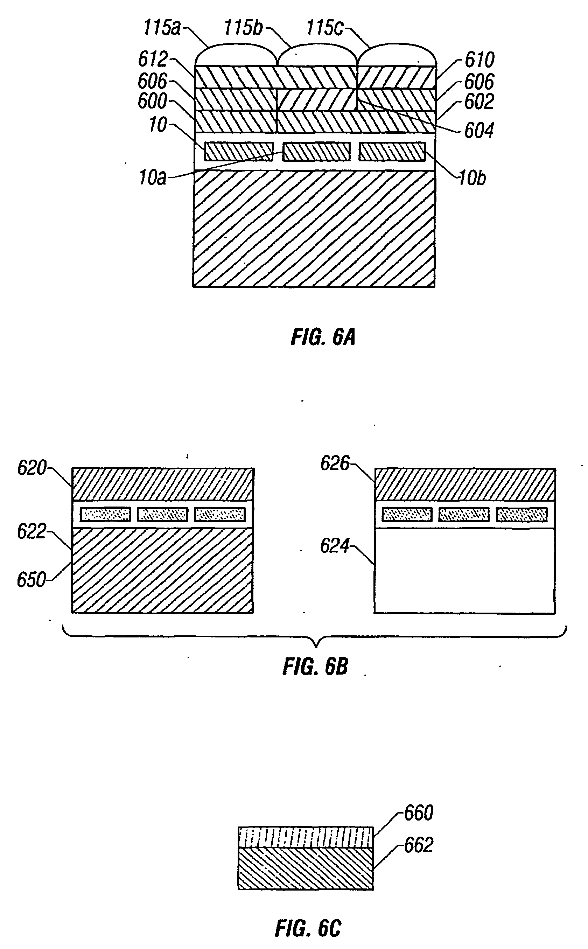

FIG. 6 is a schematic diagram of an alternate embodiment of the cell of FIG. 3A with a storage well and an additional charge coupled device stage, and includes a graph of the surface potential in the charge transfer section.

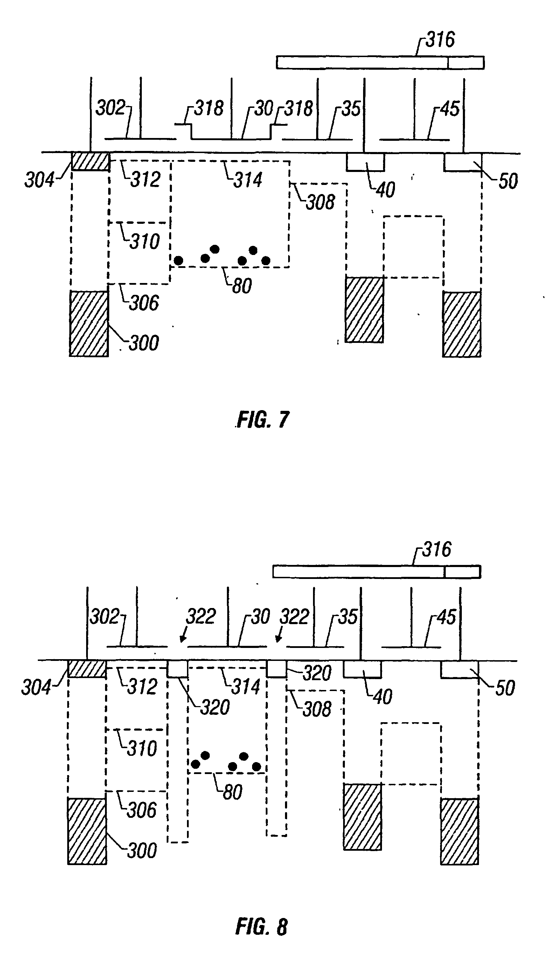

FIG. 7 is a schematic diagram of an alternate embodiment of the cell of FIG. 3A with an electronic shutter and overlapping photogate, including a graph of the surface potential in the charge transfer section; and
FIG. 8 is a schematic diagram and surface potential graph of the embodiment of FIG. 7 without the overlapping photogate.

### DETAILED DESCRIPTION OF THE PREFERRED EMBODIMENTS

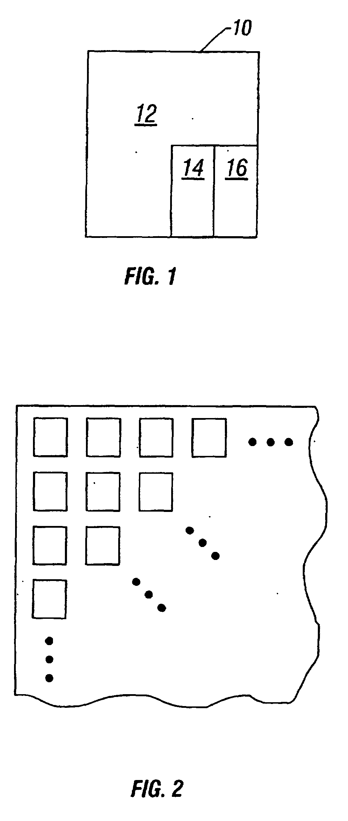

FIG. 1 is a simplified block diagram of one pixel cell 10 of a focal plane array of many such cells formed in an integrated circuit. Each cell 10 includes a photogate 12, a charge transfer section 14 adjacent the photogate 12 and a readout circuit 16 adjacent the charge transfer section 14. FIG. 1 shows these elements with the square area being labelled the pixel, but it should be understood that these elements can alternatively be physically located outside the area called the pixel.

FIG. 2 shows a focal plane array of many cells 10 formed on a silicon substrate 20.

FIG. 3A is a simplified schematic diagram of a pixel cell 10 and its associated processing. Each pixel cell 10 includes a photogate area and its associated circuitry (30 - 50) and row decoder elements 55,60. FIG. 3A shows the photogate 12 having a relatively large photogate electrode 30 overlying the substrate. The charge transfer section 14 has a transfer gate electrode 35 adjacent the photogate electrode 30, a floating diffusion 40, a reset electrode 45 and a drain diffusion 50. The readout circuit 16 has a source follower field effect transistor (FET) 55, a row select FET 60, a load FET 65 and a correlated double sampling circuit 70.

The surface potential diagram of FIG. 4 shows the photogate electrode 30 being held by a photogate signal PG at a positive voltage to form a potential well 80 in the substrate 20 in which photo-generated charge is accumulated during an integration period. The transfer gate electrode 35 is initially held at a less positive voltage by a transfer gate signal TX to form a potential barrier 85 adjacent the potential well 80. The floating diffusion 40 is connected to the gate of the source follower FET 55 whose drain is connected to a drain supply voltage VDD. The reset electrode 45 is initially held by a reset signal RST at a voltage corresponding to the voltage on the transfer gate 30 to form a potential barrier 90 thereunder. The drain supply voltage VDD connected to the drain diffusion 50 creates a constant potential well 95 underneath the drain diffusion 50.

During the integration period, electrons accumulate in the potential well 80 in proportion to photon flux incident on the substrate 20 beneath the photogate electrode 30. At the end of the integration period, the surface potential beneath the floating diffusion 40 is quickly reset to a potential level 100 slightly above the potential well 95. This is accomplished by the reset signal RST temporarily increasing to a higher positive voltage to temporarily remove the potential barrier 90 and provide a downward potential staircase from the transfer gate potential barrier 85 to the drain diffusion potential well 95, as indicated in the drawing of FIG. 4. After the reset gate 45 is returned to its initial potential (restoring the potential barrier 90), the readout circuit 70 briefly samples the potential of the floating diffusion 40, and then the cell 10 is ready to transfer the photo-generated charge from beneath the photogate electrode 30. For this purpose, the photogate signal PG decreases to a less positive voltage to form a potential barrier 105 beneath the photogate electrode 30 and thereby provide a downward staircase surface potential from the photogate electrode 30 to the potential well 100 beneath the floating diffusion 40. This operation transfers the charge from beneath the photogate electrode 30 to the floating diffusion 40, changing the potential of the floating diffusion 40 from the level (100) at which it was previously reset to a new level 107 indicative of the amount of charge accumulated during the integration period. This new potential of the floating diffusion 40 is sensed at the source of the source follower FET 55. However, before the readout circuit 70 samples the source of the source follower FET 55, the photogate signal PG returns to its initial (more positive) voltage. The entire process is repeated for the next integration period.

The readout circuit 70 has a signal sample and hold (S/H) circuit including an S/H FET 200 and a signal store capacitor 205 connected through the S/H FET 200 and through the row select FET 60 to the source of the source follower FET 55. The other side of the capacitor 205 is connected to a source bias voltage VSS. The one side of the capacitor 205 is also connected to the gate of an output FET 210. The drain of the output FET is a connected through a column select FET 220 to a signal sample output node VOUTS and through a load FET 215 to the drain voltage VDD. A signal called "signal sample and hold" (SHS) briefly turns on the S/H FET 200 after the charge accumulated beneath the photogate electrode 30 has been transferred to the floating diffusion 40, so that the capacitor 205 stores the source voltage of the source follower FET 55 indicating the amount of charge previously accumulated beneath the photogate electrode 30.

The readout circuit 70 also has a reset sample and hold (S/H) circuit including an S/H FET 225 and a signal store capacitor 230 connected through the S/H FET 225 and through the row select FET 60 to the source of the source follower FET 55. The other side of the capacitor 230 is connected to the source bias voltage VSS. The one side of the capacitor 230 is also connected to the gate of an output FET 240. The drain of the output FET 240 is connected through a column select FET 245 to a reset sample output node VOUTR and through a load FET 235 to the drain voltage VDD. A signal called "reset sample and hold" (SHR) briefly turns on the S/H FET 225 immediately after the reset signal RST has caused the resetting of the potential of the floating diffusion 40, so that the capacitor 230 stores the voltage to which the floating diffusion has been reset.

The readout circuit provides a special form of correlated double sampling of the potential of the floating diffusion, allowing the charge integrated beneath the photogate 12 during each integration period to be obtained at the end of each integration period from the difference between the voltages at the output nodes VOUTS and VOUTR of the readout circuit 70. This minimizes the effects of kTC noise because the difference between VOUTS and VOUTR is independent of any variation in the reset voltage on the floating diffusion 40. It also suppresses fixed pattern noise produced by threshold variations in transistor 55. It also suppresses 1/F noise produced by transistors 55,60 and 65.

FIG. 5 shows a transparent refractive microlens layer 110 which may be deposited over the top of the focal plane array of FIG. 2. The microlens layer 110 has spherical portions 115 centered over each of the cells 10 and contoured so as to focus light toward the center of each photogate 12. This has the advantage of using light that would otherwise fall outside of the optically active region of the photogate 12. For example, at least some of the light that is ordinarily incident on either the charge transfer section 14 or the readout circuit 16 (FIG. 1) would be sensed in the photogate area with the addition of the microlens layer 110. This has the effect of maximizing real estate - the portions of the substrate which include the non-photogate area are focused to another point.

FIG.s 6A and 6B show an alternative embodiment which uses color filtering. Color filtering enables spatial separation of color in an imaging device. CCD devices, for example, commonly use kind of color separation in this way.

The preferred system allows a plurality of pixels to have different color filtering properties to provide a color filtering effect. Typically this is done by using the color filters in some array form: For example, alternate green filters interspersed with red and blue filters. An exemplary filter operation would use green/red/green/blue/green/red/green/blue with that pattern continuing for the length of the array.

According to this embodiment, color filters are used to supplement the lens operation of FIG. 5.

The preferred system embodies its operation in one of the two forms shown in FIG.s 6A and 6B. The first form shown in FIG. 6A uses a polymer color filter array. Such polymer color filter arrays are well-known in the art. Layer 600 is preferably a red layer, and is first deposited over the entire chip. Subsequent to deposition, an etching technique is used to remove the red filter area 600 from everywhere except over the desired pixel 10. A planarization layer 602 covers the removed areas to thereby planarize that surface, thereby flattening the surface. Blue filter 604 is next deposited over pixel 10A. Blue filter 604 is similarly etched such that it only covers the desired pixel 10A. The remaining area is planarized by a second planarization layer 606. Finally, a green filter 610 is formed over that planarized layer, covering pixel 10B. Planarization layer 612 flattens the resulting area so that green filter 610 only covers the pixel 10B.

Each pixel, including the polymer layer, is covered by microlens 115A; 115B and 115C. The microlenses modify the incoming light in conjunction with the polymer layer. The light is therefore changed by both microlenses 115A-115C and CFA parts 610, 604, and 600. Each pixel, therefore, preferably receives light that has been altered by the lens and altered by the color filter array.

This polymer color filter array sacrifices a certain amount of resolution of the scene. Each pixel of the scene is imaged by three pixels, and hence some of the pixels are dedicated to a different color.

An alternative embodiment shown in FIG. 6B does not lose resolution, but instead requires multiple chips to form any image. This would form a 3-chip camera. One chip 650 has all its pixels covered by a red filter 620. Hence that chip images the red scene - either the red components or the complement to the red components. Analogously, the other chips include green filters and blue filters. The three chips together form the entire image.

Yet another embodiment uses a wavelength-converting phosphor 660 as shown in FIG. 6C. A wavelength-converting phosphor is typically tuned to accept radiation of a desired wavelength, e.g.,, ultra-violet or x-ray. Typically the silicon underlayer is not responsive to that same wavelength. Therefore, the phosphor emits a photon of the proper type to properly excite the underlying silicon 662, when receiving this radiation. A preferred example is that the phosphor 660 is sensitive to x-ray, but emits a photon of green light that is detected by the circuitry 662 which can be a sensor of any of the kinds described herein.

While the FIG. 6C embodiment contemplates using the wavelength-converting phosphor over an entire surface of the device, it is also possible to use a pixelation effect. A shadow mask is used to mask the phosphor. The phosphor is only deposited where allowed by the shadow mask.

It should also be understood that these same techniques could be embodied in other focal plane and photodiode applications, and that the above color filter array is not limited to single readout circuit per pixel systems.

Preferably, the focal plane array corresponding to FIG.s 1-4 is implemented in MOS silicon or CMOS, or any other technology which is compatible with an industry standard CMOS fabrication process. Preferably, each of the FETs is a MOSFET, the FETs 55, 60, 65, 200 and 225 being n-channel devices and the FETs 210, 220, 225, 230, 240, 245 being p-channel devices. The n-channel MOSFETS and the CCD channel underlying the gate electrodes 30, 35, 45 and the diffusions 40 and 50 may be located in a p-well while the remaining (p-channel) devices are located outside of the p-well. The gate voltage VLP applied to the gates of the p-channel load FETs 215 and 235 is a constant voltage on the order of +2.5 volts. The gate voltage VLN applied to the n-channel load FET 65 is a constant voltage on the order of +1.5 volts.

The charge transfer section 14 preferably uses only a single CCD stage between the photogate 12 and the floating diffusion 40 in the specific embodiment of FIG. 3A. This means that there is no loss due to charge transfer inefficiency and therefore there is no need to fabricate the device with a special CCD process. As a result, the readout circuit 70 as well as the output circuitry of the FETs 55, 60 and 65 can be readily implemented as standard CMOS circuits, making them relatively inexpensive. However, any suitable charge coupled device architecture may be employed to implement the charge transfer section 14, including a CCD having more than one stage. For example, two or three stages may be useful for buffering two or three integration periods.

Other implementations of the concept of the invention may be readily constructed by the skilled worker in light of the foregoing disclosure. For example, the floating diffusion 40 may instead be a floating gate electrode. The signal and reset sample and hold circuits of the readout circuit 70 may be any suitable sample and hold circuits. Moreover, shielding of the type well-known in the art may be employed defining an aperture surrounding the photogate 12. Also, the invention may be implemented as a buried channel, n-well, or p-channel device.

Another feature which is useful for eliminating fixed pattern noise due to variations in FET threshold voltage across the substrate 20 is a shorting FET 116 across the sampling capacitors 205, 235. After the accumulated charge has been measured as the potential difference between the two output nodes VOUTS and VOUTR, a shorting signal VM is temporarily applied to the gate of the shorting FET 116 and the VOUTS-to-VOUTR difference is measured again. This latter difference is a measure of the disparity between the threshold voltages of the output FETs 210, 240, and may be referred to as the fixed pattern difference. The fixed pattern difference is subtracted from the difference between VOUTS and VOUTR measured at the end of the integration period, to remove fixed pattern noise.

As previously mentioned herein, a floating gate may be used instead of the floating diffusion 40. Such a floating gate is indicated schematically in FIG. 3A by a simplified dashed line floating gate electrode 41.
In one preferred implementation, the area of the photogate 12 (i.e.,, the photogate electrode 30) is preferably L-shaped as shown in FIG. 1, and is about 100 square microns; the transfer gate electrode 35 and the reset gate electrode were each about 1.5 microns by about 6 microns; the photogate signal PG was varied between about +5 volts (its more positive voltage) and about 0 volts (its less positive voltage; the transfer gate signal TX was about +2.5 volts; the reset signal RST was varied between about +5 volts (its more positive voltage) and about +2.5 volts (its less positive voltage); the drain diffusion 50 was held at about +5 volts.

The array structure of FIG.s 1-4 can be modified to incorporate a preferred column parallel approach. The term column parallel approach refers to a portion of the readout circuitry being connected to the bottom on the columns of the array. This allows an entire row of the array to be processed at one time. This column approach is in contrast to a spatially parallel processing approach where each pixel has its own processing circuitry (e.g., the embodiment of FIG.s 1-4), or a serial processing approach where the output of each pixel is sequentially feed to a single processor for processing.

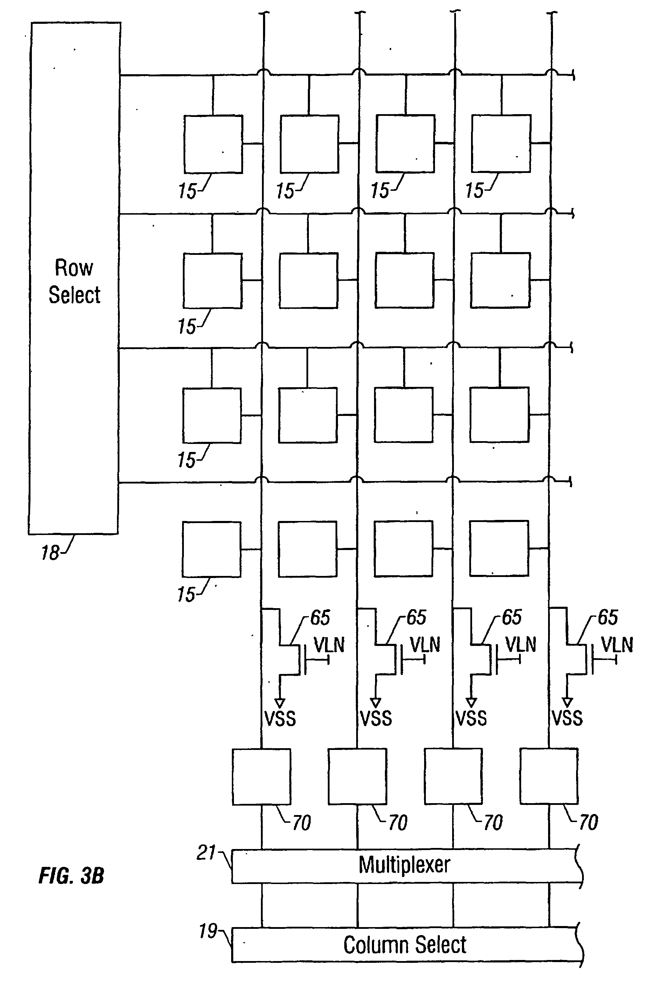

FIG. 3B shows a column parallel approach where the load FET 65 and correlated double sampling circuit 70 are deleted from the individual pixel cells 10. Instead, each cell 10 in a column of the array is connected to a common load FET 65 and sampling circuit 70. The common elements are preferably located at the bottom of each column of the array. This column parallel array structure has a significant advantage. Since the load FET 65 and sampling circuit 70 have been removed from the pixel cells 10, there is more photosensitive cell area available. Thus, the resolution of each cell 10 is improved. The column parallel array structure is read out by selecting an entire row using standard row and column select circuitry 18, 19. Selecting a row, among other things, results in the accumulated charge being transferred from the photogate potential well 80 of each cell 10 in the row to its associated floating diffusion 40. Thereafter, the sampling circuits 70 at the bottom of each column "read" the connected pixel cell 10 in the manner described previously. A standard multiplexer 21 is then employed to output the "read" pixel cell values, either in parallel or serially.

The previous described pixel cell structure of FIG.s 3A or 3B and 4 can be further modified to include simultaneous integration of the array. In the originally-described pixel cell structure, charge accumulated in the photogate well 80 during the integration period was transferred directly to the floating diffusion 40. However, in many applications, not all the cells in the array could be read out at the same time. The charge that was transferred to the floating diffusion 40 would degrade over time.

One counter measure to this problem is to transfer only the accumulated charge for pixel cells that are currently being read out. For example, as described in connection with the embodiment of fig. 3B, only a row of the array is read out at one time. However, since only a portion of the array is read out, the resulting image from all the cells represents a series of lines, each corresponding to the observed scene at a different time. If the observed scene is changing, the resulting image may be motion-skewed, i.e., may have some portions that represent a different instant of time than others. At the same time, it is important that noise be minimized.

FIG. 6 shows an embodiment that accomplishes these goals according to the technique of the present invention, by incorporating additional structure into the basic cell structure. A storage gate electrode 260 overlies a storage potential well 265 in the substrate. The storage well 265 is a supplemental charge storage area which stores charge from the main light collection area -- photogate well 80. The size of storage well 265 depends on the necessary charge amount. In low light situations, for example, the area of the optical charge storage area may need to be large in order to collect as much light as possible. However, the charge storage area may never fill. In that case, storage well needs only enough area to store the intended amount of charge. For maximum light-collection capability, however, storage well 265 preferably has a similar surface area as the photogate well 80 to ensure that all the charge accumulated in the photogate well 80 can be transferred to the storage well 265.

The non-photosensitive portion of the pixel cell is preferably shielded from optical radiation by an opaque layer 270, e.g., a metal layer. The non-photosensitive portion of the cell includes the area underlying the intermediate transfer gate 255 and storage gate 260, as well as the transfer gate 35, floating diffusion 40, reset gate 45, and V + drain 50.

This optical shielding layer 270 minimizes the possibility that optically generated noise affects the charge stored in the storage well 265, or the other identified structures.

The process for operating this modified pixel cell is similar to that described previously. A control system 700 supplies voltage. The charge accumulated in the photogate well 80 under the photogate electrode 30 during the integration period is then transferred across the intermediate transfer gate 255 and into the storage potential well 265. The charge remains in well 265 until readout. The voltage VPg on the photogate electrode 30 is initially greater than the voltage VTg of intermediate transfer gate 255. When the image acquisition is complete, VPg is reduced to less than VTg. This forms potential barrier 105 beneath the photogate electrode 30, thereby providing a downward staircase surface potential from the photogate electrode 30 to the storage well 265 which is being held at a higher positive voltage than the intermediate transfer gate 255. During readout, the floating diffusion node 40 is reset and the reset voltage sampled, as discussed previously. At the time of the readout, the charge is transferred from the storage well 265 over the transfer gate potential 85 and into the floating diffusion node 40, where it is sampled, in the same way the charge was transferred from the photogate well 80 to the node 40 in the first-described embodiment of FIG.s 3A-B and 4.

The techniques of the storage well 265 and transferring of the charge from the photogate well 80 to the storage well 265 after the integration period enables simultaneous integration. The accumulated charge in each cell is transferred to its associated storage well 265 at the end of the integration period. Therefore, all the pixel cells, or a part as desired, can be used to image the observed scene for the duration of the prescribed integration period, regardless of when each individual cell is to be read out. This allows a "snapshot" image to be stored.

The storage well 265 provides a stable structure in which to store the transferred charge. However, an important part of the present invention is the ability to store shuttered information in a way that still allows correlated double sampling.

Different techniques of double sampling are well known in the art. The inventors of the present invention, however, desire to obtain the most possible accuracy. This requires determining the amount of incoming flux with errors that are within the single electron range. The inventors recognize that because of quantum imperfections and fluctuations, it is not possible to obtain certainty about a reset level unless that reset level is actually monitored, each time at the beginning of the cycle. Some previous systems have correlated the reset that occurs at the end of one cycle with the full value at the end of the next cycle. This provides, on the average, a good approximation of the value.. However, since we can never be precisely sure of the exact value which is present at the beginning and end of a cycle, this system allows less accuracy than the present invention. This embodiment allows the flowing diffusion to be monitored prior to the introduction of charge thereto. In this way, the system of the present invention enables a more accurate detection than that which has been available previously. Moreover, the accumulated and transferred charge can remain in the storage well 265, preferably substantially isolated from noise or leakage, until the time of readout for that cell. The charge is transferred to the floating diffusion 40. The above-described technique ensures there is minimal degradation of the signal produced even though the charge was stored for some period of time, and improved detection values.

This simultaneous integration pixel cell structure trades off the ability to store a snapshot against the fill factor of the cell. The intermediate transfer gate 255 and storage gate 260 take up room on the substrate and are shielded from optical radiation. Therefore, the proportion of the cell that is actively photosensitive is reduced. This may have the effect of lowering the resolution of the cell for any particular cell size.

A certain amount of this real estate can be reclaimed using the technique shown in FIG. 6A. FIG. 6A shows one particular pixel, including a photosensitive part, and a non-photosensitive part. As described in the preferred embodiment, the non-photosensitive part is covered by blocking layer 270. Planarization layer 602, 606, 612, preferably a transparent layer which does not affect the optical radiation passing therethrough, covers the photosensitive portion. This forms a flat surface.

As in previous embodiments, a color filter 600, 604, 610 is optionally formed over the planarized layer including the optical blocking layer and the planarization layer. FIG. 6A shows the color filter formed over the entire pixel, but it should be understood that the color filter need not cover the entire pixel since part of this is blocked.

The entire structure is covered by lens 115a-115c, which is formed to refract light incoming from over the non-photosensitive area 612 towards the photosensitive area 610. This lens can recapture some of the light which would otherwise fall on the shielded area and refract it to increase some of the resolution.

Another embodiment of the active pixel sensor array allows control over the length of the integration period using alternate electronic shutter shown in FIG. 7. Shutter gate 302 and a shutter drain diffusion 304 are positioned relative to the photogate 30 to bleed off charge away from the photogate. Although shown as a separate elements in FIG. 7, in practice the shutter drain diffusion 304 may also act as the previously described V+ drain 50, either for the same pixel or of an adjacent pixel in the array. In either case, the shutter drain diffusion 304 is maintained at a positive voltage exceeding the potential of the other gates to form a potential well shown as 300 under drain diffusion 304.

The shutter gate 302 and shutter drain diffusion 304 act together to selectively prevent charge accumulation in the associated pixel or allow the accumulation of an optically generated charge under the photogate 30 when desired. Accumulation of charge is prevented by biasing shutter gate 302 to a positive voltage which exceeds the bias on the photogate 30. This forms a potential barrier 306. At the same time the bias on the transfer gate 35 is made less than that on the photogate electrode 30 to form potential barrier 308. This creates a downward staircase in surface potential from the photogate electrode 30 via well 306 to the potential well 300 beneath the shutter drain diffusion 304. This downward staircase allows any optically generated charge in the photogate potential well 80 spills across the shutter gate 302 into potential well 300 and into shutter drain diffusion 304. In this mode, the electronic shutter is effectively "closed" since optically generated charge is not allowed to accumulate.

To begin the accumulation of charge in the photogate potential well 80, the shutter gate bias is changed to a voltage lower than the photogate 30, but slightly higher than the transfer gate 35. This forms potential barrier 310. The inventors prefer making the shutter gate bias slightly higher than that of the transfer gate 35. In the case of a very strong optical signal, the photogate potential well 80 fills until charge begins to flow over the shutter gate potential 310 into the shutter drain diffusion 304. Therefore, charge does not leak past the transfer gate potential 308 and into the floating diffusion node 40 where it could disrupt the readout process described earlier. This specific expedient allows a lateral anti-blooming control in the pixel cell and provides an additional advantage to the electronic shutter structure.

At the end of a selected integration period, the charge accumulated under the photogate 30 is shifted to the floating diffusion node 40 (or storage well) by lowering the shutter gate bias to a voltage below the bias voltage of the transfer gate 35 to form potential barrier 312, and then pulsing the photogate bias to a similar lower voltage to form potential barrier 314. This causes the charge accumulated during the selected integration period to flow over the transfer gate potential 308 and into the floating diffusion node 40. After the transfer of charge, the electronic shutter can be closed once again, or a new integration cycle can be initiated by adjusting the shutter gate and photogate biases as described above.

The section of the pixel cell from the diffusion node 40 side edge of the photogate 30, through the transfer gate 35, floating diffusion node 40, reset gate 45, and V+ drain 50 is preferably covered with an opaque layer 316, such as one made of metal, to block optical radiation and reduce optically-generated noise in the underlying substrate.

In a preferred implementation of the electronic shutter, the shutter gate 302 is biased to the V+ drain potential (i.e., about 5 volts), the photogate 30 is biased to about 4 volts, and the transfer gate 35 is biased to about 1.2 volts, in the "closed" mode. To initiate the integration mode (i.e., "open" the shutter), the shutter gate potential is changed to about 1.5 volts, while the other gate potentials remain the same. The accumulated charge is transferred to the floating diffusion node 40, by setting the shutter gate 302 at 0 volts and the photogate 30 is pulsed to this same potential.

The electronic shutter makes it possible to set a desired integration time for all or some of the cells. The integration time for any one cell is set by simply "opening" the electronic shutter for a predetermined period of time.

The pixel cell in FIG. 7 uses overlapping gates 318. The photogate 30 overlaps the shutter gate 302, and transfer gate 35, over the surface of the pixel cell substrate. This overlapping gate structure enhances the charge transfer efficiency discussed previously. This enhancement results from reducing the area of the substrate that would otherwise have to exist between adjacent gates. This area is placed under the influence of one of the gate potentials. Accordingly, the charge transfer is facilitated. However, there is a tradeoff. The formation of overlapping gates 318 in a CMOS device requires a double poly process. Advanced CMOS fabrication processes which use only a single layer of poly can be used. Therefore, spaced gates with intervening gaps are a necessity in these single poly layer CMOS implementations. In such a structure, floating diffusions 320 are created in the substrate under the gaps 322 between the photogate 30, shutter gate 302, and the transfer gate 35, as shown in FIG. 8.

Any overlap described herein can be replaced a floating diffusion with non-overlapping poly from a single poly layer.

Although only a few embodiments have been described in detail above, those having ordinary skill in the art will certainly understand that many modifications are possible in the preferred embodiment without departing from the teachings thereof.

All such modifications are intended to be encompassed within the following claims.

## Claims

1. An optical device, comprising:
a light collection area (12) comprising a photogate (30) and a photogate storage area (80) which is controlled by said photogate, said photogate storage area operable to accumulate charge under control of said photogate;
a charge transfer mechanism (14) adjacent said photogate having a sensing node (40) and at least one charge coupled device stage capable of transferring charge from said photogate storage area to said sensing node;
a shutter drain diffusion (304), spaced from said photogate storage area, for connection to a shutter drain bias voltage;
an electronic shutter gate (302) disposed between said photogate (30) and said shutter drain diffusion (304) operable to set at a first voltage (306) for draining charge from said photogate storage area (80) to said shutter drain diffusion (304) to prevent charge accumulation in said photogate storage area (80) and at a second voltage (310) which allows for charge accumulation in said photogate storage area (80) to produce a photo-induced output at said sensing node (40); **characterized by**
a drain diffusion (50) for connection to a drain bias voltage (VDD), and
a reset gate (45) between the sensing node (40) and the drain diffusion (50), the drain diffusion and the reset gate adapted to operate collectively to drain charge from the sensing node after sensing,
in which the drain diffusion is also the shutter drain diffusion of the optical device or of an adjacent optical device on the same substrate.

2. The device of claim 1 further including:
a readout circuit (16, 70) electrically coupled to the sensing node and comprising:
a sensing transistor (55) that buffers an output from said sensing node (40) and converts said output into an output electrical signal, and
a correlated double sampling circuit (70) that samples and correlates values of said output electrical signal before and after accumulation of charge in said photogate storage area for each accumulation cycle.

3. The device of claim 1 wherein said sensing node (40) comprises a floating node.

4. The device of claim 3 wherein the charge transfer mechanism (14) includes a transfer gate (35) between said floating node (40) and said photogate (30).

5. The device of claim 1 further including:
a supplemental charge storage area (265), physically separated from said light collection area (12);
wherein said charge transfer mechanism (14) includes an intermediate charge transfer device (255) coupled between said light collection area (12) and said supplemental charge storage area (265) selectively operable to transfer charge in said light collection area to said supplemental charge storage device (265); and
wherein said sensing node (40) is connected to receive charge from said supplemental charge storage area (265) under the control of a control element (35).

6. The device of claim 5 wherein the photogate storage area (80) has a first size and said supplemental charge storage area (265) has a second size smaller than said first size.

7. The device of claim 5 wherein said photogate storage area (80) and said supplemental charge storage area (265) are of substantially the same size.

8. The device of claim 5 further comprising a control system (700) that provides a potential on the photogate (30) that is initially higher than a potential on the charge transfer device (255) to allow charge to be accumulated therein.

9. The device of claim 5 wherein said sensing node (40) comprises a floating node, and further comprising a first element (225) adapted to sample a voltage on the floating node prior to transfer of charge thereto and a second element (200) adapted to sample a voltage on the floating node after transfer of charge thereto.

10. The device of claim 5 further comprising an optical shield (270) optically covering at least a portion of the supplemental charge storage area (265).

11. The device of claim 10 further comprising a microlens (115) overlying the optical shield (270) and refracting at least a portion of the light impinging over an area of the optical shield to the light collection area (12).

12. The device of claim 1 further including an optical blocking layer (270) covering said charge transfer mechanism but leaving said light collection area (12) optically unblocked.

13. The device of claim 12 further including a control system (700) adapted to bias said photogate (30) to a first level that allows said photogate storage area (80) to accumulate charge and then to bias said photogate to a second level (105) that allows charge to pass into said charge transfer mechanism.

14. The device of claim 4 wherein said electronic shutter gate (302) is biased to a potential (310) which is higher than a bias potential (308) of said transfer gate (35) when in an off state, to prevent blooming.

15. The device of claim 3 further including:
a control system (700) adapted to control said photogate (30), said charge transfer mechanism (14), said electronic shutter gate (302) and said shutter drain diffusion (304) such that a charge on said sensing node (40) is sampled at a beginning of a first period of integration, and a charge on said sensing node (40) is sampled at an end of said same first period of integration; and said shutter is turned on to prevent said accumulation of charge at least at one of said beginning and end of said first period; and
a circuit (70) which correlates said beginning and said end samples to form a correlated measurement.

16. The device of claim 5 further including:
a control system (700) adapted to control said photogate (30), said charge transfer mechanism (14), said electronic shutter gate (302) and said shutter drain diffusion (304) such that a charge on said sensing node (40) is sampled at a beginning of a first period of integration, and a charge on said sensing node is sampled at an end of said same first period of integration, and said shutter is turned on to prevent said accumulation of charge at least at one of said beginning and end of said first period; and such that a voltage is applied to said photogate storage area (80) at an end of an integration period to transfer charge from said photogate storage area (80) to said supplemental charge storage area (265), and wherein charge is not transferred from said supplemental charge storage area (265) to said sensing node (40) until after said beginning sample is taken at said beginning of said first period of integration.

17. The device of claim 1 or claim 5 in which said electronic shutter gate (302) and said shutter drain diffusion (304) are adapted to selectively remove charge from said photogate storage area (80) when biased to a predetermined potential (306).

18. The device of claim 4 including a control circuit adapted to set the electronic shutter gate (302) to a first potential level (306) to prevent charge from accumulating in said photogate storage area (80) and to a second potential level (310) to allow charge to accumulate in said photogate storage area (80) and to a third potential level (312), lower than the first (306) and the second (310) potential levels, to prevent accumulated charge in said photogate storage area migrating to said shutter drain diffusion (304) during charge transfer from said photogate storage area, said second potential level being higher than a level required on said transfer gate (35) in order to effect transfer of charge to said floating node (40).

19. The device of claim 5 in which at least one of said photogate (30), a gate (260) controlling said supplementary charge storage area (265) and a gate (302) controlling said electronic shutter overlaps an adjacent one of said gates.

20. The device of claim 19 wherein said gates (30, 260, 302) are formed by a double poly system.

21. An imaging device comprising a plurality of optical devices each according to any one of claims 1 to 20 arranged in an active pixel sensor array.

22. An imaging device comprising a plurality of optical devices each according to claim 1, formed on a monolithic semiconductor integrated circuit substrate (20) in a focal plane array, each device further including a read out circuit (16) on said substrate.

23. The imaging device of claim 21 wherein each shutter drain diffusion (304) is the drain diffusion (50) of an adjacent optical device.

24. The imaging device of claim 22 wherein, in each optical device:
said photogate (30) is connected to a photogate bias voltage;
a transfer gate (35) of said charge transfer mechanism (14) is connected to a transfer gate bias voltage; and
wherein, in a closed shutter mode in which the shutter gate bias voltage is greater than the photogate bias voltage which is in turn greater than the transfer gate bias voltage, the electronic shutter drains charge from said underlying portion of the substrate.

25. The imaging device of claim 24, wherein:
in an integrating mode wherein the photogate bias voltage is greater than the shutter gate bias voltage, charge accumulates in said underlying portion of said substrate.

26. The imaging device of claim 25 wherein:
in the integrating mode, the shutter gate bias voltage is greater than the transfer gate bias voltage, thereby providing anti-blooming control.

27. The imaging device of claim 25 wherein:
in a charge transfer mode, where the shutter gate bias voltage is smaller than the transfer gate bias voltage and the photogate bias voltage is pulsed to a smaller voltage than the transfer gate bias voltage, charge is transferred from said underlying portion of said substrate to said sensing node (40).

28. The imaging device of claim 22 wherein in each optical device a first gap (322) exists between the photogate (30) and the charge transfer mechanism (14) and a second gap (322) exists between the photogate (30) and the electronic shutter gate (302), and wherein each photogate further comprises:
a first overlying section (318) which overlies the first gap; and
a second overlying section (318) which overlies the second gap.

29. The imaging device of claim 22 wherein in each optical device a first gap (322) exists between the photogate (30) and the charge transfer mechanism (14) and a second gap (322) exists between the photogate and the electronic shutter gate (302) each imaging device further comprising:
a first floating diffusion (320) underlying the first gap; and
a second floating diffusion (320) underlying the second gap.

## Patentansprüche

1. Optische Vorrichtung mit:
einem Lichtsammelbereich (12) mit einem Photogate (30) und einem Photogate-Speicherbereich (80), der von dem Photogate gesteuert wird, wobei der Photogate-Speicherbereich so betätigbar ist, dass er Ladung unter der Steuerung des Photogates akkumuliert,
einem Ladungsübertragungsmechanismus (14) angrenzend an das Photogate, mit einem Abtastknoten (40) und mindestens einer ladungsgekoppelten Vorrichtungastufe, welche eine Ladung von dem Photogate-Speicherbereich zu dem Abtastknoten übertragen kann,
einer Verschluß- bzw. Blenden-Drainableitung (304), die von dem Photogate-Speicherbereich beabstandet ist, zum Verbinden mit einer Verschluß-Drain-Vorspannung,
einem elektronischen Verschlussgate (302), das zwischen dem Photogate (30) und der Verschluß-Drainableitung (304) angeordnet ist und so betätigbar ist, dass es eine erste Spannung (306) zum Ableiten von Ladung aus dem Photogate-Speicherbereich (80) zu der Verschluß-Drainableitung (304), um eine Ladungsansammlung in dem Photogate-Speicherbereich (80) zu verhindern, und eine zweite Spannung (310), die eine Ladungsansammlung in dem Photogate-Speicherbereich (80) ermöglicht, um eine licht-induzierte Ausgabe an den Abtastknoten (40) zu erzeugen, einstellen kann,
**gekennzeichnet durch**
eine Drainableitung (50) zum Verbinden mit einer Drain-Vorspannung (VDD), und
ein Rückstellgate (45) zwischen dem Abtastknoten (40) und der Drainableitung (50), wobei die Drainableitung und das Rückstellgate gemeinsam arbeiten können, um Ladung aus dem Abtastknoten nach der Abtastung abzuleiten,
wobei die Drainableitung auch die Verschluß-Drainableitung der optischen Vorrichtung oder einer angrenzenden optischen Vorrichtung auf dem gleichen Träger ist.

2. Vorrichtung nach Anspruch 1, ferner mit:
einer mit dem Abtastknoten elektrisch gekoppelten Ausleseschaltung (16,70), mit:
einem Abtast-Transistor (55), der eine Ausgabe von dem Abtastknoten (40) puffert und die Ausgabe in ein elektrisches Ausgangssignal umwandelt, und
einer korrelierten Doppel-Abtastschaltung (70), welche Werte bzw. Größen des elektrischen Ausgangssignals vor und nach der Ansammlung von Ladung in dem Photogate-Speicherbereich für jeden Akkumulationszyklus abtastet und korreliert.

3. Vorrichtung nach Anspruch 1, wobei der Abtastknoten (40) einen erdfreien (floating) Knoten umfaßt.

4. Vorrichtung nach Anspruch 3, wobei der Ladungsübertragungsmechanismus (14) ein Übertragungsgate (35) zwischen dem erdfreien Knoten (40) und dem Photogate (30) aufweist.

5. Vorrichtung nach Anspruch 1, ferner mit:
einem zusätzlichen Ladungsspeicherbereich (265), der physisch von dem Lichtsammelbereich (12) getrennt ist,
wobei der Ladungsübertragungsmechanismus (14) ein Zwischen-Ladungsübertragungsgerät (255) aufweist, das zwischen dem Lichtsammelbereich (12) und dem zusätzlichen Ladungsspeicherbereich (265) gekoppelt ist und selektiv betätigbar ist, um Ladung in dem Lichtsammelbereich zu dem zusätzlichen Ladungsspeichergerät (265) zu übertragen, und
wobei der Abtastknoten (40) so verbunden ist, dass er Ladung von dem zusätzlichen Ladungespeicherbereich (265) unter der Steuerung eines Steuerelements (35) aufnimmt.

6. Vorrichtung nach Anspruch 5, wobei der Photogate-Speicherbereich (80) eine erste Größe hat und der zusätzliche Ladungsspeicherbereich (265) eine zweite Größe hat, die kleiner ist als die erste Größe.

7. Vorrichtung nach Anspruch 5, wobei der Photogate-Speicherbereich (80) und der zusätzliche Ladungsspeicherbereich (265) im wesentlichen die gleiche Größe aufweisen.

8. Vorrichtung nach Anspruch 5, ferner mit einem Steuersystem (700), das dem Photogate (30) ein Potential liefert, welches anfänglich höher ist als ein Potential der Ladungsübertragungsvorrichtung (255), um ein Ansammeln von Ladung zu ermöglichen.

9. Vorrichtung nach Anspruch 5, wobei der Abtastknoten (40) einen erdfreien Knoten umfaßt und ferner ein erstes Element (225), das eine Spannung an dem erdfreien Knoten vor der Übertragung einer Ladung an diesem abtasten kann, und ein zweites Element (200), das eine Spannung an dem erdfreien Knoten nach der Übertragung einer Ladung an diesem abtasten kann, umfaßt.

10. Vorrichtung nach Anspruch 5, ferner mit einer optischen Abschirmung (270), welche mindestens einen Teil des zusätzlichen Ladurigaspeicherbereichs (265) abdeckt.

11. Vorrichtung nach Anspruch 10, ferner mit einer Mikrolinse (115), die über der optischen Abschirmung (270) liegt und mindestens einen Teil des über einem Bereich der optischen Abschirmung auftreffenden Lichts zu dem Lichtsammelbereich (12) hin bricht bzw. ablenkt.

12. Vorrichtung nach Anspruch 1, ferner mit einer optischen Blockierschicht (270), welche den Ladungsübertragungsmechanismus abdeckt, aber den Lichtsammelbereich (12) optisch unblockiert lässt.

13. Vorrichtung nach Anspruch 12, ferner mit einem Steuersystem (700), welches das Photogate (30) auf einen ersten Pegel vorspannen kann, der dem Photogate-Speicherbereich (80) eine Ladungsansammlung ermöglicht, und dann das Photogate auf einen zweiten Pegel (105) vorspannen kann, der einen Übergang der Ladung auf den Ladungsübertragungsmechanismus ermöglicht.

14. Vorrichtung nach Anspruch 4, wobei das elektronische Verschlussgate (302) auf ein Potential (310) vorgespannt ist, das höher ist als ein Vorspannungspotential (308) des Übertragungsgates (35) in einem abgeschalteten Zustand, um eine Reflexminderung (blooming) zu verhindern.

15. Vorrichtung.nach Anspruch 3, ferner mit:
einem Steuersystem (700), welches das Photogate (30), den Ladungsübertragungsmechanismus (14), das elektronische Verschlussgate (302) und die Verschluß-Drainableitung (304) so steuern kann, dass eine Ladung an dem Abtastknoten (40) zu Beginn einer ersten Integrationsperiode abgetastet wird, und eine Ladung an dem Abtastknoten (40) an einem Ende der ersten Integrationsperiode abgetastet wird, und dass der Verschluß eingeschaltet wird, um eine Ladungsansammlung zu Beginn und/oder am Ende der ersten Periode verhindert, und
einer Schaltung (70), welche die Abtastwerte zu Beginn und am Ende korreliert, um eine korrelierte Messung zu erstellen.

16. Vorrichtung nach Anspruch 5, ferner mit:
einem Steuersystem (700), welches das Photogate (30), den Ladungsübertragungsmechanismus (14), das elektronische Verschlussgate (302) und die Verschluß-Drainableitung (304) so steuern kann, dass eine Ladung am Abtastknoten (40) zu Beginn einer ersten Integrationsperiode abgetastet wird, und
eine Ladung am Abtastknoten am Ende dieser ersten Integrationsperiode abgetastet und der Verschluß eingeschaltet wird, um eine Ladungsansammlung zu Beginn und/oder am Ende der ersten Periode zu verhindern, und derart, dass eine Spannung an den Photogate-Speicherbereich (80) am Ende einer Integrationsperiode angelegt wird, um Ladung von dem Photogate-Speicherbereich (80) über den zusätzlichen Ladungssspeicherbereich (265) zu übertragen, und wobei Ladung von dem zusätzlichen Ladungsspeicherbereich (265) zu dem Abtastknoten (40) nicht übertragen wird, bis der Beginn-Abtastwert zu Beginn der ersten Integrationsperiode abgenommen wurde.

17. Vorrichtung nach Anspruch 1 oder Anspruch 5, wobei das elektronische Verschlussgate (302) und die Verschluß-Drainableitung (304) selektiv Ladung aus dem Photogate-Speicherbereich (80) entfernen können, wenn sie auf ein vorbestimmtes Potential (306) vorgespannt sind.

18. Vorrichtung nach Anspruch 4, mit einer Steuerschaltung, welche das elektronische Verschlussgate (302) auf einen ersten Potentialpegel (306) setzen kann, um zu verhindern, dass sich Ladung in dem Photogate-Speicherbereich (80) ansammelt, auf einen zweiten Potentialpegel (310), um eine Ansammlung von Ladung in dem Photogate-Speicherbereich (80) zu ermöglichen, sowie auf einen dritten Potentialpegel (312), der niedriger ist als der erste (306) und der zweite (310) Potentialpegel, um zu verhindern, dass in dem Photogate-Speicherbereich angesammelte Ladung während einer Ladungsübertragung von dem Photogate-Speicherbereich zu der Verschluß-Drainableitung (304) migriert, wobei der zweite Potentialpegel höher ist als ein an dem Übertragungsgate (35) erforderlicher Pegel, um eine Übertragung von Ladung zu dem erdfreien Knoten (40) durchzuführen.

19. Vorrichtung nach Anspruch 5, wobei das Photogate (30) und/oder ein Gate (260), welches den zusätzlichen Ladungsspeicherbereich (265) steuert, und/oder ein Gate (302), welches den elektronischen Verschluß steuert, ein angrenzendes Gate überlappt.

20. Vorrichtung nach Anspruch 19, wobei die Gates (30,260,302) durch ein Doppel-Polysystem gebildet sind.

21. Abbildungsvorrichtung mit mehreren optischen Vorrichtungen jeweils gemäß einem der Ansprüche 1 bis 20, die in einem aktiven Pixelsensor-Array angeordnet sind.

22. Abbildungsvorrichtung mit mehreren optischen Vorrichtungen, jeweils gemäß Anspruch 1, die auf einem monolithischen Halbleiter-IC-Träger (20) als ein Brennebenen-Array ausgebildet sind, wobei jede Vorrichtung ferner eine Ausleseschaltung (16) auf dem Träger aufweist.

23. Abbildungsvorrichtung nach Anspruch 21, wobei jede Verschluß-Drainableitung (304) die Drainableitung (50) einer angrenzenden optischen Vorrichtung ist.

24. Abbildungsvorrichtung nach Anspruch 22, wobei bei jeder optischen Vorrichtung:
das Photogate (30) mit einer Photogate-Vorspannung verbunden ist,
ein Übertragungsgate (35) des Ladungsübertragungsmechanismus (14) mit einer Übertragungsgate-Vorspannung verbunden ist, und
wobei in einem geschlossenen Verschlussmodus, bei dem die Verschlussgate-Vorspannung größer ist als die Photogate-Vorspannung, die ihrerseits größer ist als die Übertragungsgate-Vorspannung, der elektronische Verschluss Ladung von dem darunterliegenden Abschnitt des Trägers ableitet.

25. Abbildungsvorrichtung nach Anspruch 24, wobei:
in einem integrierenden Modus, bei dem die Photogate-Vorspannung größer ist als die Verschlussgate-Vorspannung, sich Ladung in dem darunterliegenden Abschnitt des Trägers ansammelt.

26. Abbildungsvorrichtung nach Anspruch 25, wobei:
in dem integrierenden Modus die Verschlussgate-Vorspannung größer ist als die Übertragungsgate-Vorspannung, wodurch eine Anti-Blooming-Steuerung bereitgestellt wird.

27. Abbildungsvorrichtung nach Anspruch 25, wobei:
in einem Ladungsübertragungsmodus, bei dem die Verschlussgate-Vorspannung kleiner ist als die Übertragungsgate-Vorspannung, und die Photogate-Vorspannung auf eine kleinere Spannung gepulst ist als die Übertragungsgate-Vorspannung, eine Ladung von dem darunterliegenden Abschnitt des Trägers zu dem Abtastknoten (40) übertragen wird.

28. Abbildungsvorrichtung nach Anspruch 22, wobei bei jeder optischen Vorrichtung ein erster Zwischenraum (322) zwischen dem Photogate (30) und dem Ladungsübertragungsmechanismus (14) besteht, und ein zweiter Zwischenraum (322) zwischen dem Photogate (30) und dem elektronischen Verschlussgate (302) besteht, und wobei jedes Photogate ferner umfaßt:
einen ersten darüberliegenden Abschnitt (318), der über dem ersten Zwischenraum liegt, und
einem zweiten darüberliegenden Abschnitt (318), der über dem zweiten Zwischenraum liegt.

29. Abbildungsvorrichtung nah Anspruch 22, wobei bei jeder optischen Vorrichtung ein erster Zwischenraum (322) zwischen dem Photogate (30) und dem Ladungsübertragungsmechanismus (14) besteht, und ein zweiter Zwischenraum (322) zwischen dem Photogate und dem elektronischen Verschlussgate (302) besteht, wobei jede Abbildungsvorrichtung ferner umfaßt:
eine erste erdfreie Ableitung (320), die unter dem ersten Zwischenraum liegt, und
eine zweite erdfreie Ableitung (320), die unter dem zweiten Zwischenraum liegt.

## Revendications

1. Dispositif optique, comprenant :
une zone de collecte de lumière (12) comprenant une grille photonique (30) et une zone de stockage de grille photonique (80), qui est commandée par ladite grille photonique, ladite zone de stockage de grille photonique étant utilisable pour accumuler des charges sous commande de ladite grille photonique ;
un mécanisme à transfert de charges (14) adjacent à ladite grille photonique ayant un noeud de détection (40) et au moins un étage de dispositif à couplage de charges capable de transférer des charges de ladite zone de stockage de grille photonique audit noeud de détection ;
une diffusion de drain d'obturateur (304), espacée de ladite zone de stockage de grille photonique, pour connexion à une tension de polarisation de drain d'obturateur ;
une grille d'obturateur électronique (302) disposée entre ladite grille photonique (30) et ladite diffusion de drain d'obturateur (304) utilisable pour définir une première tension (306) pour drainer des charges de ladite zone de stockage de grille photonique (80) vers ladite diffusion de drain d'obturateur (304) pour empêcher l'accumulation de charges dans ladite zone de stockage de grille photonique (80) et une deuxième tension (310) qui permet l'accumulation de charges dans ladite zone de stockage de grille photonique (80) pour produire une sortie photo-induite audit noeud de détection (40) ; **caractérisé par**
une diffusion de drain (50) pour connexion à une tension de polarisation de drain (VDD), et
une grille de réinitialisation (45) entre le noeud de détection (40) et la diffusion de drain (50), la diffusion de drain et la grille de réinitialisation étant adaptées pour fonctionner collectivement pour drainer des charges du noeud de détection après détection,
dans lequel la diffusion de drain est aussi la diffusion de drain d'obturateur du dispositif optique ou d'un dispositif optique adjacent sur le même substrat.

2. Dispositif selon la revendication 1 **caractérisé en ce qu'**il comprend en outre :
un circuit de lecture (16, 70) couplé électriquement au noeud de détection et comprenant :
un transistor de détection (55) qui met en mémoire tampon une sortie provenant dudit noeud de détection (40) et convertit ladite sortie en un signal électrique de sortie, et
un double circuit d'échantillonnage corrélé (70) qui échantillonne et corrèle les valeurs dudit signal électrique de sortie avant et après accumulation de charges dans ladite zone de stockage de grille photonique pour chaque cycle d'accumulation.

3. Dispositif selon la revendication 1 dans lequel ledit noeud de détection (40) comprend un noeud flottant.

4. Dispositif selon la revendication 3 dans lequel le mécanisme à transfert de charges (14) inclut une grille de transfert (35) entre ledit noeud flottant (40) et ladite grille photonique (30).

5. Dispositif selon la revendication 1 comprenant en outre :
une zone de stockage de charges supplémentaire (265), physiquement séparée de ladite zone de collecte de lumière (12) ;
dans lequel ledit mécanisme à transfert de charges (14) inclut un dispositif à transfert de charge intermédiaire (255) couplé entre ladite zone de collecte de lumière (12) et ladite zone de stockage de charges supplémentaire (265) utilisable sélectivement pour transférer des charges dans ladite zone de collecte de lumière audit dispositif de stockage de charges supplémentaire (265) ; et
dans lequel ledit noeud de détection (40) est connecté pour recevoir des charges de ladite zone de stockage de charge supplémentaire (265) sous la commande d'un élément de commande (35).

6. Dispositif selon la revendication 5 dans lequel la zone de stockage de grille photonique (80) a une première taille et ladite zone de stockage de charges supplémentaire (265) a une deuxième taille plus petite que ladite première taille.

7. Dispositif selon la revendication 5 dans lequel ladite zone de stockage de grille photonique (80) et ladite zone de stockage de charges supplémentaire (265) sont sensiblement de même taille.

8. Dispositif selon la revendication 5 comprenant en outre un système de commande (700) qui fournit un potentiel sur la grille photonique (30) qui est initialement supérieur à un potentiel sur le dispositif de transfert de charge (255) pour permettre aux charges d'y être accumulées.

9. Dispositif selon la revendication 5 dans lequel ledit noeud de détection (40) comprend un noeud flottant, et comprend en outre un premier élément (225) adapté pour échantillonner une tension sur le noeud flottant avant transfert de charges vers celui-ci, et un deuxième élément (200) adapté pour échantillonner une tension sur le noeud flottant après transfert de charges vers celui-ci.

10. Dispositif selon la revendication 5 comprenant en outre un écran optique (270) couvrant optiquement au moins une partie de la zone de stockage de charge supplémentaire (265).

11. Dispositif selon la revendication 10 comprenant en outre une microlentille (115) recouvrant l'écran optique (270) et réfractant au moins une partie de la lumière empiétant sur une zone de l'écran optique jusqu'à la zone de collecte de lumière (12).

12. Dispositif selon la revendication 1 comprenant en outre une couche de blocage optique (270) couvrant ledit mécanisme à transfert de charges mais laissant ladite zone de collecte de lumière (12) optiquement non bloquée.

13. Dispositif selon la revendication 12 comprenant en outre un système de commande (700) adapté pour polariser ladite grille photonique (30) à un premier niveau qui permet à ladite zone de stockage de grille photonique (80) d'accumuler des charges puis de polariser ladite grille photonique à un deuxième niveau (105) qui permet aux charges de passer dans ledit mécanisme à transfert de charges.

14. Dispositif selon la revendication 4 dans lequel ladite grille d'obturateur électronique (302) est polarisée à un potentiel (310) qui est supérieur à un potentiel de polarisation (308) de ladite grille de transfert (35) quand elle est dans un état bloqué, pour empêcher l'éblouissement.

15. Dispositif selon la revendication 3 comprenant en outre :
un système de commande (700) adapté pour commander ladite grille photonique (30), ledit mécanisme à transfert de charges (14), ladite grille d'obturateur électronique (302) et ladite diffusion de drain d'obturateur (304) de sorte que des charges sur ledit noeud de détection (40) sont échantillonnées à un début d'une première période d'intégration, et des charges sur ledit noeud de détection (40) sont échantillonnées à une fin de ladite même première période d'intégration ; et ledit obturateur est activé pour empêcher ladite accumulation de charges au moins à un desdits début et fin de ladite première période ; et
un circuit (70) qui corrèle les échantillons dudit début et de ladite fin pour former une mesure corrélée.

16. Dispositif selon la revendication 5 comprenant en outre :
un système de commande (700) adapté pour commander ladite grille photonique (30), ledit mécanisme à transfert de charges (14), ladite grille d'obturateur électronique (302) et ladite diffusion de drain d'obturateur (304) de sorte que des charges sur ledit noeud de détection (40) soient échantillonnées à un début d'une première période d'intégration, et des charges sur ledit noeud de détection soient échantillonnées à une fin de ladite même première période d'intégration, et ledit obturateur est activé pour empêcher ladite accumulation de charges au moins à l'un desdits début et fin de ladite première période ; et de sorte qu'une tension soit appliquée à ladite zone de stockage de grille photonique (80) à une fin d'une période d'intégration pour transférer des charges de ladite zone de stockage de grille photonique (80) à ladite zone de stockage de charges supplémentaire (265), et où des charges ne sont pas transférées de ladite zone de stockage de charges supplémentaire (265) audit noeud de détection (40) tant que ledit échantillon de début est prélevé audit début de ladite première période d'intégration.

17. Dispositif selon la revendication 1 ou la revendication 5 dans lequel ladite grille d'obturateur électronique (302) et ladite diffusion de drain d'obturateur (304) sont adaptées pour éliminer sélectivement des charges de ladite zone de stockage de grille photonique (80) quand elle est polarisée à un potentiel prédéterminé (306).

18. Dispositif selon la revendication 4 comprenant un circuit de commande adapté pour définir la grille d'obturateur électronique (302) à un premier niveau de potentiel (306) pour empêcher des charges de s'accumuler dans ladite zone de stockage de grille photonique (80), et à un deuxième niveau de potentiel (310) pour permettre à des charges de s'accumuler dans ladite zone de stockage de grille photonique (80), et à un troisième niveau de potentiel (312), inférieur au premier (306) et au deuxième (310) niveau de potentiel, pour empêcher des charges accumulées dans ladite zone de stockage de grille photonique de migrer vers ladite diffusion de drain d'obturateur (304) pendant le transfert de charges de ladite zone de stockage de grille photonique, ledit deuxième niveau de potentiel étant supérieur à un niveau requis sur ladite grille de transfert (35) afin d'effectuer le transfert de charges audit noeud flottant (40).

19. Dispositif selon la revendication 5 dans lequel au moins une de ladite grille photonique (30), d'une grille (260) commandant ladite zone de stockage de charge supplémentaire (265) et d'une grille (302) commandant ledit obturateur électronique chevauche l'une adjacente desdites grilles.

20. Dispositif selon la revendication 19 dans lequel lesdites grilles (30, 260, 302) sont formées par un double poly-système.

21. Dispositif d'imagerie comprenant une pluralité de dispositifs optiques chacun selon l'une quelconque des revendications 1 à 20 disposés dans une matrice de détecteurs à pixels actifs.

22. Dispositif d'imagerie comprenant une pluralité de dispositifs optiques chacun selon la revendication 1, formés sur un substrat monolithique de circuit intégré à semi-conducteur (20) dans une matrice de plan focal, chaque dispositif comprenant en outre un circuit de lecture (16) sur ledit substrat.

23. Dispositif d'imagerie selon la revendication 21 dans lequel chaque diffusion de drain d'obturateur (304) est la diffusion de drain (50) d'un dispositif optique adjacent.

24. Dispositif d'imagerie selon la revendication 22 dans lequel, dans chaque dispositif optique :
ladite grille photonique (30) est connectée à une tension de polarisation de la grille photonique ;
une grille de transfert (35) dudit mécanisme à transfert de charges (14) est connectée à une tension de polarisation de la grille de transfert ; et
dans lequel, dans un mode obturateur fermé dans lequel la tension de polarisation de grille d'obturateur est supérieure à la tension de polarisation de la grille photonique qui à son tour est supérieure à la tension de polarisation de la grille de transfert, les drains d'obturateur électronique se chargent à partir de ladite partie sous-jacente du substrat.

25. Dispositif d'imagerie selon la revendication 24, dans lequel :
dans un mode d'intégration dans lequel la tension de polarisation de la grille photonique est supérieure à la tension de polarisation de la grille de l'obturateur, des charges s'accumulent dans ladite partie sous-jacente dudit substrat.

26. Dispositif d'imagerie selon la revendication 25 dans lequel :
dans le mode d'intégration, la tension de polarisation de la grille de l'obturateur est supérieure à la tension de polarisation de la grille de transfert, fournissant ainsi une commande anti-éblouissement.

27. Dispositif d'imagerie selon la revendication 25 dans lequel :
dans un mode à transfert de charges, où la tension de polarisation de grille d'obturateur est inférieure à la tension de polarisation de la grille de transfert et la tension de polarisation de la grille photonique est injectée à une tension inférieure à la tension de polarisation de la grille de transfert, des charges sont transférées de ladite partie sous-jacente dudit substrat audit noeud de détection (40).

28. Dispositif d'imagerie selon la revendication 22 dans lequel dans chaque dispositif optique un premier espace (322) existe entre la grille photonique (30) et le mécanisme à transfert de charges (14) et un deuxième espace (322) existe entre la grille photonique (30) et la grille d'obturateur électronique (302), et dans lequel chaque grille photonique comprend en outre :
une première section de recouvrement (318) qui recouvre le premier espace ; et
une deuxième section de recouvrement (318) qui recouvre le deuxième espace.

29. Dispositif d'imagerie selon la revendication 22 dans lequel, dans chaque dispositif optique, un premier espace (322) existe entre la grille photonique (30) et le mécanisme à transfert de charges (14) et un deuxième espace (322) existe entre la grille photonique et la grille d'obturateur électronique (302), chaque dispositif d'imagerie comprenant en outre :
une première diffusion flottante (320) sous-jacente au premier espace ; et
une deuxième diffusion flottante (320) sous-jacente au deuxième espace.
